# EUROPEAN PATENT APPLICATION

(11) **EP 4 675 017 A1**
(43) Date of publication of application: **07.01.2026**
(21) Application number: 24763686.3
(22) Date of filing: 19.02.2024
(51) Int. Cl.: C30B 29/36, C30B 25/20, C30B 33/06, H01L 21/02, H01L 21/336, H01L 29/12, H01L 29/78

(54) **SUBSTRATE FOR SIC SEMICONDUCTOR DEVICES, SIC BONDED SUBSTRATE, SIC POLYCRYSTAL SUBSTRATE, AND SIC POLYCRYSTAL SUBSTRATE MANUFACTURING METHOD**

(30) Priority: 27.02.2023 JP 2023028550
(71) Applicant: SUMITOMO METAL MINING CO., LTD., Tokyo 105-8716 (JP)
(72) Inventor: TAHARA, Daisuke, Tokyo 105-8716 (JP); AOKI, Katsutoshi, Tokyo 105-8716 (JP)
(74) Representative: TBK
(86) International application number: PCT/JP2024/005779
(87) International publication number: WO 2024/181205

(57) **Abstract**

Provided is a substrate for a SiC semiconductor device, a SiC bonded substrate, a SiC polycrystal substrate, and a SiC polycrystal substrate manufacturing method, which can suppress an amount of warping of the substrate after back grinding to 1.0 mm or less in the substrate for a SiC semiconductor device having a structure in which the SiC polycrystal substrate and a SiC single crystal substrate are bonded.

A substrate for a SiC semiconductor device, wherein the substrate is formed by stacking a support substrate made of SiC polycrystal, a SiC single crystal substrate bonded to the surface of the support substrate, a SiC single crystal epitaxial layer formed on the surface of the SiC single crystal substrate, and a component of a semiconductor element formed on the SiC single crystal epitaxial layer, in this sequence, wherein the surface of the support substrate that is not bonded to the SiC single crystal substrate is a ground surface, and wherein the amount of warping of the ground surface is 1.0 mm or less.

## Description

### Technical field

The present invention relates to a silicon carbide (hereinafter sometimes referred to as "SiC") polycrystal substrate and its manufacturing method, a SiC bonded substrate obtained by bonding a SiC single crystal substrate to a SiC polycrystal substrate, and a substrate for a SiC semiconductor device in which a SiC single crystal epitaxial layer and a semiconductor circuit are formed on the SiC bonded substrate.

### Background Art

SiC is a wide band gap semiconductor with a wide band gap of 2.2 to 3.3 eV, and because of its excellent physical and chemical properties, it has been researched and developed as an environmentally resistant semiconductor material. In recent years, SiC has attracted attention as a material for power devices such as high-voltage and high-output electronic devices and highfrequency electronic devices, and short-wavelength optical devices from blue to ultraviolet, and research and development of SiC has been intensified. However, it is difficult to manufacture high-quality large-diameter single crystals of SiC, which has hindered the practical use of SiC devices.

To solve this problem, an improved Lely process has been developed in which sublimation recrystallization is performed using a SiC single crystal substrate as a seed crystal. By using this improved Lely process, SiC single crystals can be grown while controlling the crystal polytype (4H-SiC, 6H-SiC, 15R-SiC, etc.), carrier type, and impurity concentration of the SiC single crystal. This technology has significantly reduced the crystal defect density, and the practical application of Schottky barrier diodes (SBDs) and field effect transistors (MOSFETs) on the substrate has progressed.

However, in the improved Lely process, which uses a SiC single crystal substrate as a seed crystal, the manufacturing cost of the SiC single crystal substrate is high due to the slow crystal growth rate and the high processing cost when processing the SiC single crystal ingot into a wafer through a process mainly consisting of cutting and polishing. This high manufacturing cost has also been a factor that has hindered the practical application of SiC devices, and there has been a strong demand for the development of technology that can provide SiC substrates for semiconductor element applications, especially for high-voltage, high-power electronic devices, at low cost.

Therefore, a technology has been provided for manufacturing a semiconductor substrate (hereinafter, sometimes referred to as a "SiC bonded substrate") that combines a low-cost support substrate portion with a high-quality SiC single crystal by using a high-quality SiC single crystal only for the device formation layer portion and fixing it to a support substrate (a material having strength, heat resistance, and cleanliness that can withstand the device manufacturing process: for example, SiC polycrystal) using a bonding method that does not involve the formation of an oxide film at the bonding interface (see, for example, Patent Literature 1). In particular, SiC bonded substrates using SiC polycrystal as a support substrate have an advantage over using SiC single crystal substrates alone in that they enable reduced manufacturing costs while taking advantage of the properties of SiC single crystal when applied to power devices. With the spread of SiC single crystal substrates, attention is being paid to SiC bonded substrates that can be manufactured more inexpensively.

On the other hand, problems related to the "warping" of the substrate in the manufacturing process of devices using SiC single crystal substrates have also become apparent. In general, the degree of "warping" of the substrate is considered to be very important in the device manufacturing process. This is because a substrate with a large warp may cause an error in the automatic transport of devices in the device manufacturing process, or may cause a problem in which the substrate cannot be held on the processing table. In addition, even if the substrate can be held on the processing table due to the large warp of the substrate, the substrate may not be sufficiently flat, and for example, in the exposure process (lithography process), a part of the substrate surface may be out of focus and a clear mask image may not be formed. The effect of this defocus phenomenon is greater the finer the circuit. Also, the warp of the substrate may also be a cause for concern about a decrease in yield in the dicing process and the package assembly process. In response to this, for example, according to Patent Literature 2, as a single crystal SiC substrate having a surface in which processing damage is removed from the front and back of the substrate by CMP or diamond polishing, the single crystal SiC substrate has a small warp of the substrate, which is explained by the distortion and residual stress obtained by Raman spectroscopy and X-ray method is provided. Also, according to Patent Literature 3, a SiC polycrystal molded body having a small warp explained by the residual stress value measured by the X-ray method is provided.

### Citation List

### Patent Literature

Patent Literature 1: JP 2015-15401 A
Patent Literature 2: JP 2015-59073 A
Patent Literature 3: JP 2021-54666 A

### Summary of the invention

### Problem to be solved by the invention

Substrate warping also occurs during thinning processing, such as back grinding (BG), after mounting the surface circuit pattern in the manufacturing process of a vertical power device in which the current flow direction is the thickness direction of the substrate. In this thinning processing process, it is necessary to remove about 40 to 50% of the original substrate thickness. For example, in a 6-inch diameter SiC single crystal substrate, the thickness after thinning processing by grinding is about 175 to 200 µm compared to the plate thickness of 350 µm, so the amount of grinding is large, and grinding processing with high processing efficiency is generally adopted. In a substrate for a semiconductor device using a SiC single crystal substrate that is not bonded, the substrate warp is suppressed to about 1 mm or less, and no problems due to the above-mentioned warp occur. In contrast, in the case of a SiC bonded substrate in which a SiC polycrystal substrate and a SiC single crystal substrate are bonded, the warp after back grinding exceeds 1 mm, and there is a risk of problems due to the warp occurring in the later process, such as transport errors and problems in which the substrate cannot be held on the processing table.

This warping during back grinding occurs because a processing damage layer is generated on the back surface of the substrate by the grinding process, and the difference in the state of the processed surfaces on the front and back of the substrate causes the Twyman effect, resulting in large warping of the substrate. On the other hand, in chemical mechanical polishing (CMP), which does not involve a processing damage layer, large warping of the substrate is unlikely to occur, but the polishing speed is very slow, about 1/100, compared to grinding, and the cost is high. Therefore, back grinding is essential for thinning the substrate, rather than polishing.

Therefore, from the viewpoint of cost and manufacturing efficiency, if it is possible to provide a substrate that is less likely to warp during back grinding, assuming that only back grinding is used for thinning, the process window for grinding that can be finished to the desired processed state will be widened, and it is thought that it will be easier to optimize the back grinding design in the device manufacturing process.

The present invention has been made in view of these problems, and has an object to provide a substrate for a SiC semiconductor device, a SiC bonded substrate, a SiC polycrystal substrate, and a SiC polycrystal substrate manufacturing method, which can suppress an amount of warping of the substrate after back grinding to 1.0 mm or less in the substrate for a SiC semiconductor device having a structure in which the SiC polycrystal substrate and a SiC single crystal substrate are bonded.

### Solution to Problem

In order to solve the above problems, a substrate for a SiC semiconductor device of the present invention is the substrate for a SiC semiconductor device, wherein the substrate is formed by stacking a support substrate made of SiC polycrystal, a SiC single crystal substrate bonded to the surface of the support substrate, a SiC single crystal epitaxial layer formed on the surface of the SiC single crystal substrate, and a component of a semiconductor element formed on the SiC single crystal epitaxial layer, in this sequence, wherein the surface of the support substrate that is not bonded to the SiC single crystal substrate is a ground surface, and wherein the amount of warping of the ground surface is 1.0 mm or less.

In addition, in order to solve the above problems, the SiC bonded substrate of the present invention is formed by stacking a support substrate made of SiC polycrystal, and a SiC single crystal substrate bonded to the surface of the support substrate, wherein an amount of warping of a ground surface is 1.0 mm or less in state that the thickness of the support substrate is ground by 40 to 50% to form the ground surface by performing a back grinding process on the surface of the support substrate that is not bonded to the SiC single crystal substrate.

In addition, in order to solve the above problem, the SiC bonded substrate of the present invention is formed by stacking a support substrate made of SiC polycrystal, and a SiC single crystal substrate bonded to the surface of the support substrate, wherein an amount of warping of a ground surface is 1.0 mm or less in state that the thickness of the support substrate is ground by 40 to 44% to form the ground surface by performing a back grinding process on the surface of the support substrate that is not bonded to the SiC single crystal substrate.

In addition, in order to solve the above problem, the SiC polycrystal substrate of the present invention is the SiC polycrystal substrate used as a support substrate for a SiC bonded substrate wherein the support substrate made of SiC polycrystal and a SiC single crystal substrate bonded to the surface of the support substrate are stacked, wherein an amount of warping of a ground surface is 1.0 mm or less in state that the thickness of the support substrate is ground by 40 to 50% to form the ground surface by performing a back grinding process on the surface of the support substrate that is not bonded to the SiC single crystal substrate.

In addition, in order to solve the above problem, the SiC polycrystal substrate of the present invention is the SiC polycrystal substrate used as a support substrate for a SiC bonded substrate wherein the support substrate made of SiC polycrystal and a SiC single crystal substrate bonded to the surface of the support substrate are stacked, wherein an amount of warping of a ground surface is 1.0 mm or less in state that the thickness of the support substrate is ground by 40 to 44% to form the ground surface by performing a back grinding process on the surface of the support substrate that is not bonded to the SiC single crystal substrate.

In addition, in order to solve the above problem, a method for manufacturing a SiC polycrystal substrate of the present invention is the method for manufacturing a SiC polycrystal substrate used as a support substrate for a SiC bonded substrate, wherein the support substrate made of SiC polycrystal and a SiC single crystal substrate bonded to the surface of the support substrate are stacked, the method comprising: a film formation step of forming a SiC polycrystal film on a seed substrate; a separation step of separating the seed substrate and the SiC polycrystal film after the film formation step; a heat treatment step of heat treating the SiC polycrystal film by holding the SiC polycrystal film at 1600 °C or higher and lower than 2000 °C after the separation step; and a grinding and polishing step of grinding and polishing the SiC polycrystal film to process it into the support substrate after the heat treatment step.

The heat treatment step may be a step of holding the SiC polycrystal film at a temperature between 1700 °C and 1800 °C for 3 hours or more.

### Effects of the Invention

According to the present invention, it is possible to provide a substrate for a SiC semiconductor device, a SiC bonded substrate, a SiC polycrystal substrate, and a SiC polycrystal substrate manufacturing method, which can suppress an amount of warping of the substrate after back grinding to 1.0 mm or less in the substrate for a SiC semiconductor device having a structure in which the SiC polycrystal substrate and a SiC single crystal substrate are bonded.

### Brief Description of the Drawings

[Figure 1A] Schematic perspective view of a SiC polycrystal substrate.
[Figure 1B] Schematic perspective view of a SiC polycrystal substrate.
[Figure 2A] Schematic perspective view of a SiC bonded substrate.
[Figure 2B] Schematic perspective view of a SiC bonded substrate.
[Figure 3] Schematic cross-sectional view of a substrate for a SiC semiconductor device.
[Figure 4] Schematic cross-sectional view of a MOSFET, which is an example of a SiC semiconductor device.
[Figure 5] A flowchart showing an example of a method for manufacturing a support substrate and a SiC bonded substrate.
[Figure 6] A flowchart showing an example of a method for manufacturing a SiC semiconductor device.

### Detailed Description of Embodiments

Hereinafter, an example of an embodiment of the present invention will be described in detail with reference to the drawings, but the present invention is not limited to the embodiment.

### [SiC polycrystal substrate]

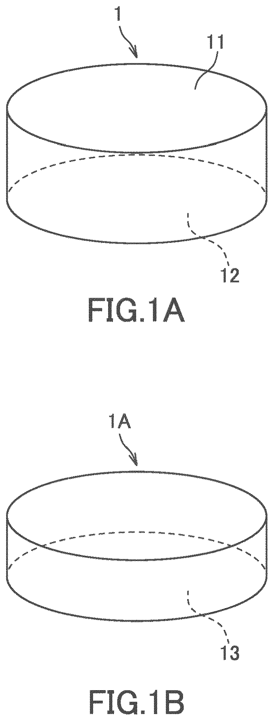

The SiC polycrystal substrate is used as a support substrate for a SiC bonded substrate in which a support substrate made of SiC polycrystal and a SiC single crystal substrate bonded to the surface of the support substrate are stacked. For example, as shown in FIG. 1A, it is a SiC polycrystal substrate 1 formed of polycrystal SiC formed by a CVD method. The SiC polycrystal substrate 1 is disc-shaped with a thickness of 200 µm to 500 µm and a size of 4 inches to 8 inches in diameter. For example, it is formed into a 6-inch disc-shaped with a thickness of about 350 µm. The SiC polycrystal of the SiC polycrystal substrate 1 is composed of any one of 4H-SiC crystal, 6H-SiC crystal, and 3C-SiC crystal, or a mixture thereof.

For example, in the SiC polycrystal substrate 1, if the surface 11 of the SiC polycrystal substrate 1 is a surface that is bonded to the SiC single crystal substrate, the opposite surface 12 of the surface 11 is a surface that is not bonded to the SiC single crystal substrate, and in the process of manufacturing the SiC semiconductor device, the opposite surface 12 is back ground to thin the SiC polycrystal substrate 1. Also, the opposite surface 12 may be a surface that is bonded to the SiC single crystal substrate, in which case the surface 11 is a surface that is not bonded to the SiC single crystal substrate, and the surface 11 is back ground.

By back grinding the SiC polycrystal substrate 1, when the thickness of the SiC polycrystal substrate 1 is ground by 40 to 50% to form the ground surface 13 (the state of the SiC polycrystal substrate 1A in FIG. 1B), the warp amount of the ground surface 13 is 1.0 mm or less.

By having the warp amount of 1.0 mm or less, problems caused by warping, such as substrate transport errors and failure to hold the substrate on the processing table in subsequent processes, can be prevented.

By performing back grinding on the SiC polycrystal substrate 1, it is preferable that the amount of warping of the ground surface 13 is 1.0 mm or less when the thickness of the SiC polycrystal substrate 1 is ground by 40 to 44% to form the ground surface 13.

In the process of thinning the SiC polycrystal substrate 1, about 40 to 50% of the original thickness of the SiC polycrystal substrate 1 is removed by back grinding, but the extent to which the SiC polycrystal substrate 1 is thinned depends on the allowable range of thickness unevenness of the SiC semiconductor device and how densely the circuit patterns can be mounted on the equipment.

Here, the SiC polycrystal substrate 1 can be ground with a grinder using a grinding wheel of No. 5000 to No. 8000. The ground surface after grinding has a surface roughness Ra of 1 nm to 5 nm.

The amount of warping of the ground surface 13 can be measured using a shape measuring device such as a three-dimensional measuring device.

### [SiC bonded substrate]

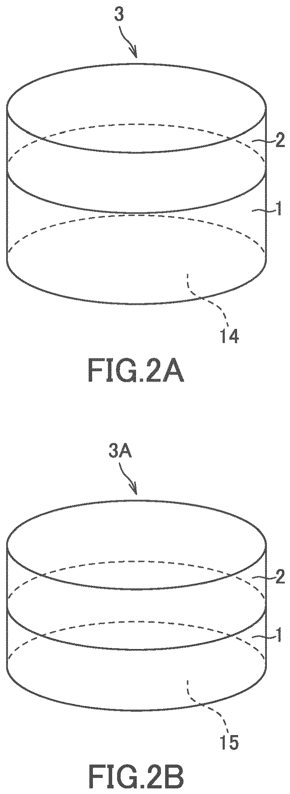

As shown in FIG. 2A, the SiC bonded substrate 3 includes a SiC polycrystal substrate 1 and a SiC single crystal substrate 2 bonded to the surface of the SiC polycrystal substrate 1. The SiC single crystal substrate 2 is a single crystal of SiC, and has a diameter of 4 to 8 inches, which is the same as the SiC polycrystal substrate 1. There is no particular limit to the thickness, but the thickness may be, for example, about 0.5 µm to 2.0 µm. The SiC bonded substrate 3 is a substrate that combines a low-cost support substrate portion and high-quality SiC single crystal by using a high-quality SiC single crystal substrate 2 for the portion forming the components of the semiconductor element and bonding it to the SiC polycrystal substrate 1, which is a support substrate.

The back surface 14 of the SiC polycrystal substrate 1, which is the surface not bonded to the SiC single crystal substrate 2, is back ground in the process of manufacturing the SiC semiconductor device, and the SiC polycrystal substrate 1 is thinned. By performing back grinding on the SiC polycrystal substrate 1, the thickness of the SiC polycrystal substrate 1 is ground by 40 to 50% to form the ground surface 15 (the state of the SiC polycrystal substrate 3A in FIG. 2B), and the amount of warping of the ground surface 15 is 1.0 mm or less. The opposite surface 12 corresponds to the back surface 14, and the ground surface 13 corresponds to the ground surface 15.

By performing back grinding on the SiC polycrystal substrate 1, the thickness of the SiC polycrystal substrate 1 is ground by 40 to 44% to form the ground surface 15, and the amount of warping of the ground surface 15 is preferably 1.0 mm or less.

By the amount of warping is 1.0 mm or less, problems caused by warping, such as substrate transport errors and failure to hold the substrate on the processing table in later processes, can be prevented.

### [Substrate for SiC semiconductor device]

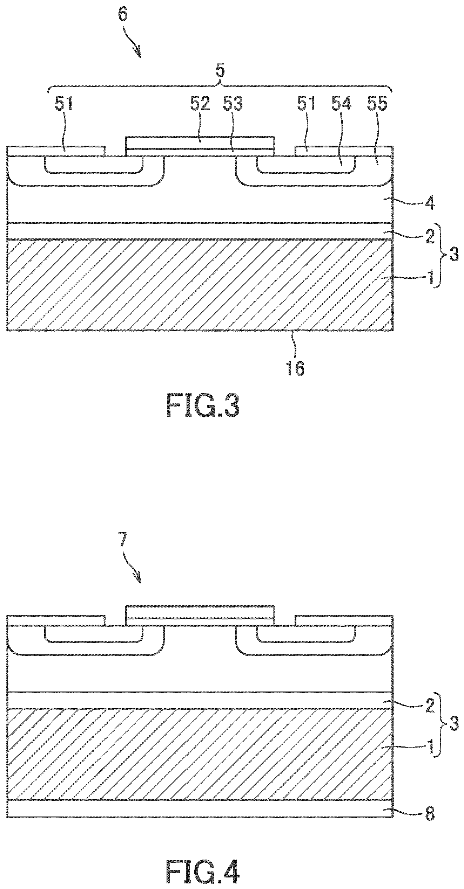

As shown in FIG. 3, the SiC semiconductor substrate 6 is a substrate in which a SiC polycrystal substrate 1, a SiC single crystal substrate 2 bonded to the surface of the SiC polycrystal substrate 1, a SiC single crystal epitaxial layer 4 formed on the surface of the SiC single crystal substrate 2, and a semiconductor element component 5 formed on the SiC single crystal epitaxial layer 4 are laminated in this sequence. Here, the semiconductor element component 5 is not particularly limited, but for example, it is composed of a source electrode 51, a gate electrode 52, a gate insulating film 53, an N⁺ source 54, and a P well 55. The SiC semiconductor device substrate 6 is a substrate in a state before being divided into individual pieces.

The ground surface 16, which is the surface of the SiC polycrystal substrate 1 that is not bonded to the SiC single crystal substrate 2, is back ground in the process of manufacturing the SiC semiconductor device, and the SiC polycrystal substrate 1 is thinned. By performing back grinding on the SiC polycrystal substrate 1, the SiC polycrystal substrate 1 is ground by 40% to 50% so as to reduce its thickness, forming a ground surface 16, and the amount of warping of the ground surface 16 is 1.0 mm or less. The ground surface 16 corresponds to the ground surface 13 and the ground surface 15.

By making the amount of warping 1.0 mm or less, problems caused by warping, such as substrate transport errors and failure to hold the substrate on the processing table in later processes, can be prevented.

### [SiC Semiconductor Device]

The SiC semiconductor device 7 of this embodiment is obtained by individually dividing the substrate for the SiC semiconductor device. Note that, as shown in FIG. 4, a semiconductor device for a vertical power device in which the current flows in the thickness direction of the substrate have a structure in which a drain electrode 8 is formed as a back electrode on the ground surface 16 of the SiC semiconductor device substrate 6.

### [Manufacturing Method of SiC Polycrystal Substrate]

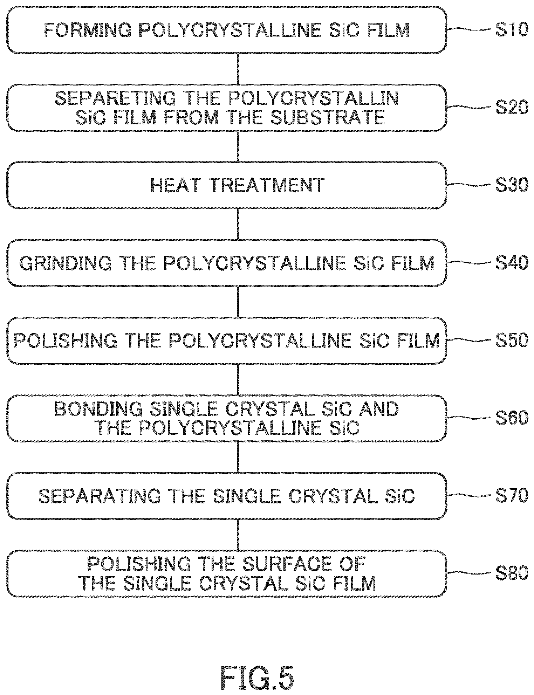

Next, a manufacturing method of a SiC polycrystal substrate will be described. This manufacturing method is a method for manufacturing a SiC polycrystal substrate 1 used as a support substrate in a SiC bonded substrate 3 in which a SiC polycrystal substrate 1 serving as a support substrate and a SiC single crystal substrate 2 bonded to the surface of the SiC polycrystal substrate 1 are stacked, and includes a film forming process, a separation process, a heat treatment process, and a grinding and polishing process, which will be described below. FIG. 5 is a flow chart of an example of a method for manufacturing the SiC polycrystal substrate 1 serving as a support substrate and the SiC bonded substrate 3, and shows steps S10 to S80.

### <Step S10 (film forming process)>

In the manufacturing method of the SiC polycrystal substrate 1, in step S10, a SiC polycrystal film is formed on a seed substrate. A seed substrate made of carbon, silicon, or the like is used as a base substrate, and a SiC polycrystal film is formed on the base substrate by a CVD method or the like.

### <Step S20 (separation process)>

Next, in step S20, the seed substrate and the SiC polycrystal film are separated. For example, the base substrate on which the SiC polycrystal film is formed can be removed by burning or dissolving with acid.

### <Step S30 (Heat Treatment Step)>

In the present invention, the object is to suppress the warping of the SiC semiconductor device substrate 6 caused by thinning the SiC polycrystal substrate 1 by the back grinding process (step S110) described later, and for this purpose, a heat treatment step is performed.

The heat treatment step is performed after the separation step of step S20 and before the back grinding process (step S110). The heat treatment of the SiC polycrystal substrate 1 is possible, for example, in the manufacturing process of the SiC polycrystal substrate 1, the manufacturing process of the SiC bonded substrate 3, or the manufacturing process of the SiC semiconductor device substrate 6 and before the back grinding process. However, as described later, if the heat treatment temperature of the SiC polycrystal film exceeds 1700 °C, the sublimation and recrystallization of SiC on the surface of the SiC polycrystal substrate 1 begins, and the surface is altered. For this reason, it is preferable to perform the heat treatment in the manufacturing process of the SiC polycrystal substrate 1, and in particular, by performing the heat treatment before the grinding process (step S40) of the SiC polycrystal substrate 1, defects such as surface deterioration caused by the heat treatment can be eliminated in the grinding process (step S40). In addition, the heat treatment process can reduce the warpage after back grinding.

In step S30, the SiC polycrystal film after the separation process is heat treated by holding it at 1600 °C or higher and lower than 2000 °C. This process may be a process in which the SiC polycrystal film is held between 1700 °C and 1800 °C for 3 hours or more.

The higher the heat treatment temperature of the SiC polycrystal film, the smaller the warpage of the substrate after the back grinding process tends to be. The heat treatment can reduce the internal stress during the formation of the SiC polycrystal substrate and reduce the warpage of the substrate. If the heat treatment temperature is lower than 1600 °C, the effect of improving the warpage of the substrate after the back grinding process is small. If the heat treatment temperature is 1700 °C or higher, sublimation and recrystallization of SiC will begin from the surface layer of the SiC polycrystal film, and if it exceeds 1800 °C, the sublimation and recrystallization of SiC will tend to proceed excessively. If the heat treatment temperature exceeds 2000 °C, crater-like pores or depressions of several µm to several tens of µm may be formed on the surface layer of the SiC polycrystal film, which is undesirable because it may cause problems in the formation of the back electrode. It is preferable to perform the heat treatment while holding the polycrystal film at 1700 °C or higher and 1800 °C or lower.

The holding time for holding the SiC polycrystal film at 1600 °C or higher and lower than 2000 °C is preferably 3 hours or more. If the holding time is less than 3 hours, the effect of improving the warpage of the substrate after back polishing may be small. There is no particular limit to the upper limit of the holding time, but it is preferably 30 hours or less. If the holding time exceeds 30 hours, the effect will not increase any more, and the longer the holding time, the greater the disadvantage in terms of manufacturing costs. The holding time is preferably 20 hours or more and 30 hours or less.

The atmosphere of the SiC polycrystal film during the heat treatment is preferably at least one of an inert gas such as argon (Ar) or nitrogen (N) or a vacuum atmosphere so as to prevent unnecessary reactions such as oxidation. For example, it is desirable that the heat treatment furnace used for the heat treatment is in a state where an inert gas is flowing, and the flow rate is not limited as long as the furnace is sufficiently filled with inert gas. The heat treatment may be performed using an atmosphere-controlled heating furnace or the like.

The SiC polycrystal film may be placed directly on any carbon support or the like, or may be filled in a rack-shaped wafer carrier, and is not limited to that form. Although multiple SiC polycrystal films may be stacked in the furnace, if a sheet-like carbon member is placed between the SiC polycrystal films as a separator, adhesion between the SiC polycrystal substrates via the sublimated and recrystallized SiC on the surface of the SiC polycrystal film can be suppressed, particularly when the heating temperature is 1700 °C or higher.

### <Steps S40 (grinding step) and S50 (polishing step)>

In step 40, the SiC polycrystal film is ground to a predetermined thickness by grinding. Then, in step 50, the surface of the SiC polycrystal film is polished by polishing. After these grinding and polishing steps, the SiC polycrystal substrate is ready to be bonded to a SiC single crystal substrate, which is the SiC polycrystal substrate 1 of the present invention that can be used as a support substrate.

### [Method of manufacturing a SiC bonded substrate]

### <Steps S60 to S80>

Steps S60 to S80 are a method of manufacturing a SiC bonded substrate. In step S60, the above-mentioned SiC polycrystal substrate 1 is bonded to a separately prepared SiC single crystal substrate 2 (bonding step). The SiC single crystal substrate 2 may be prepared by bonding a thick SiC single crystal substrate to a support substrate (step 60) using a hydrogen atom ablation peeling technique (also called Smart Cut (registered trademark)) as described in Patent Literature 1, and then separating the substrate to prepare a thin SiC single crystal substrate on the support substrate (step 70). After that, in step S80, a polishing process is performed to polish the surface of the SiC single crystal substrate 2, resulting in a SiC bonded substrate 3 including the SiC polycrystal substrate 1 and the SiC single crystal substrate 2.

The bonded SiC single crystal substrate may be a SiC single crystal produced by the improved Lely process, or a SiC single crystal formed by the CVD process.

### [Method of Manufacturing SiC Semiconductor Device]

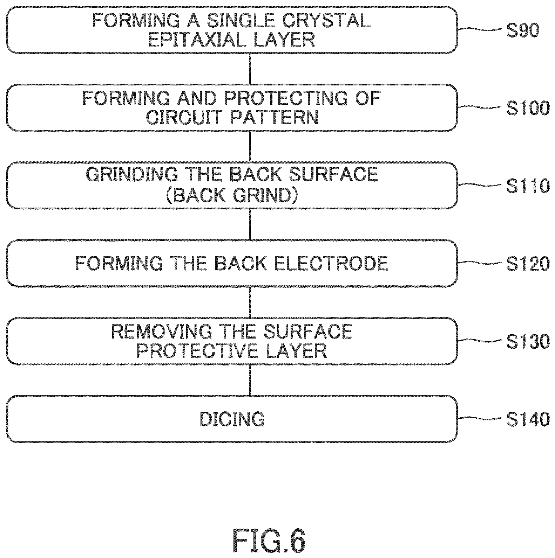

Next, a method of manufacturing the SiC semiconductor device 7 will be described. FIG. 6 is a flow chart showing an example of a method of manufacturing the SiC semiconductor device 7, showing steps S90 to S140. In step S90, the SiC single crystal epitaxial layer 4 is epitaxially grown on the surface of the SiC single crystal substrate 2, and in step S100, a circuit pattern of component 5 of a semiconductor element and the like is formed on the surface of the SiC single crystal epitaxial layer 4, and a surface protection layer for protecting the circuit pattern is formed with resin or the like. Thereafter, in step S110, the back surface opposite to the surface on which the circuit pattern is formed is ground to thin the SiC polycrystal substrate 1 and form a ground surface 16 (back grinding process). The substrate in the state in which the process up to step S110 has been completed is the SiC semiconductor device substrate 6 shown in FIG. 3. After the process of step S110, in step S120, a drain electrode 8 is formed as a back electrode on the ground surface 16 of the SiC semiconductor device substrate 6, resulting in a SiC semiconductor device 7. Note that before forming the back electrode, the ground surface 16 may be subjected to surface processing such as polishing.

Then, in step S130, the surface protection layer protecting the circuit pattern of the SiC semiconductor device 7 is removed, and in step S140, dicing is performed to cut the SiC semiconductor device 7 into dies using a rotating diamond blade or the like.

The process flow from manufacturing the SiC polycrystal substrate 1 to manufacturing the semiconductor is as shown in steps S10 to S140, but existing inspection and processing steps such as contact hole formation and probe inspection may be performed as appropriate.

In the manufacturing process of the SiC semiconductor device 7, after the component 5 of the semiconductor element are formed on the SiC single crystal epitaxial layer 4, back grinding is performed to grind the back surface. In particular, the SiC semiconductor device 7 is often used in vertical power devices in which the current flow direction is the thickness direction of the substrate, and a thinning process is performed by back grinding after mounting the surface circuit pattern in the manufacturing process of the vertical power device. In this process, it is necessary to remove about 40 to 50% of the original thickness of the SiC polycrystal substrate 1. For example, in the case of a 6-inch diameter SiC polycrystal substrate, if the substrate thickness is 350 µm, a thickness of about 175 to 200 µm is removed by grinding, so the grinding amount of SiC polycrystal is large, and grinding is generally used, which has a higher thinning efficiency than polishing. For example, in a substrate for a SiC semiconductor device using a SiC single crystal substrate that is not bonded to a SiC polycrystal substrate, the warp of the substrate after thinning the SiC single crystal substrate by back grinding can be suppressed to about 1 mm or less. By suppressing it within this range, it becomes possible to process the substrate without any problems in the subsequent process. In contrast, in the conventional technology that does not perform a heat treatment process, the warp of the substrate after thinning the SiC polycrystal substrate 1 by back grinding using a SiC bonded substrate 3 in which a SiC polycrystal substrate 1 and a SiC single crystal substrate 2 are bonded was more than 1.0 mm.

In the present invention, by performing a heat treatment process between the separation process and the grinding process, the warpage of the substrate can be suppressed to 1.0 mm or less.

### Examples

The present invention will be explained in more detail below by showing examples, but the present invention is not limited to the following examples.

### [Example 1]

### <Preparation of SiC polycrystal substrate 1>

A seed substrate formed in a disk shape made of carbon was used as a base substrate, and a 2 mm thick SiC polycrystal film was formed on the surface of the base substrate by chemical vapor deposition (CVD) (step S10). Methylchlorosilane was used as the source gas, and hydrogen and nitrogen gases were used as the carrier gas. The growth temperature in this chemical vapor deposition method was 1400 °C. After that, the base substrate was heated and removed in an air atmosphere at 1000 °C by a combustion method, and a disk-shaped SiC polycrystal film was produced (step S20). This SiC polycrystal film was heat-treated using an atmosphere-controlled heating furnace (step S30). The heating temperature was 1700 °C, the heating temperature was held for 24 hours, and the furnace atmosphere was an argon gas atmosphere. Thereafter, the surface of the SiC polycrystal film was ground and polished to be flattened (steps S40 and S50), and a SiC polycrystal substrate 1 with a diameter of 6 inches (about 150 mm) and a thickness of 350 µm was obtained.

### <Preparation of SiC bonded substrate 3>

The manufactured SiC polycrystal substrate 1 was used to prepare a SiC bonded substrate 3. As the SiC single crystal substrate 2 to be bonded to the SiC polycrystal substrate 1, a disk-shaped substrate of 4H polytype with a thickness of 350 µm, a diameter of 6 inches (about 150 mm) and a main surface orientation of <0001>, manufactured by the improved Lely process, was used. In addition, in manufacturing the SiC bonded substrate 3, a peeling technique using hydrogen atom ablation (also called Smart Cut (registered trademark)) described in Patent Literature 1 was used.

### (Step S60)

Hydrogen ions were implanted into the bonding surface of the SiC single crystal substrate 2 to be bonded to the SiC polycrystal substrate 1, and a hydrogen ion implanted layer was formed at a depth of 1.0 µm from the bonding surface. The SiC single crystal substrate 2 and the SiC polycrystal substrate 1 were attracted by an electrostatic chuck and set in a chamber. Next, the electrostatic chuck was moved to align the relative positions of the SiC single crystal substrate 2 and the SiC polycrystal substrate 1 so that the two substrates can be in contact with each other in the room temperature bonding process in the correct positional relationship. Next, the chamber was evacuated to a vacuum of 2×10⁻⁶ Pa. Next, a neutral atomic beam of argon was uniformly irradiated to the entire surface of the bonding surface of the SiC single crystal substrate 2 and the entire surface of the bonding surface of the SiC polycrystal substrate 1 using a FAB gun, and the oxide films and adsorption layers of both bonding surfaces were removed to expose the bonds and activate them. Next, while maintaining the vacuum state at room temperature, the electrostatic chuck was moved in the chamber, and the bonding surfaces of the SiC single crystal substrate 2 and the SiC polycrystal substrate 1 were brought into contact with each other in the vacuum state in the chamber and directly bonded by covalent bonds to obtain a bonded substrate.

### (Step S70)

Next, the bonded substrate was heated to 1000 °C in an inert atmosphere filled with argon gas using a furnace to form a microbubble layer in the hydrogen ion implantation layer, and the SiC single crystal substrate 2 was separated at the microbubble layer, and a thin plate-shaped SiC single crystal substrate 2 with a thickness of 1.0 µm was transferred to the SiC polycrystal substrate 1.

### (Step S80)

The surface of the SiC single crystal substrate 2 exposed in step S70 was processed by CMP polishing so as to be smooth. As a result, a SiC bonded substrate 3 was obtained.

### <Preparation of a SiC semiconductor device substrate >

Next, a SiC semiconductor device substrate 6 was prepared. Using the SiC bonded substrate 3 manufactured by the above method, a SiC single crystal epitaxial layer 4 was formed to a thickness of 20 µm on the surface of the SiC single crystal substrate 2 by chemical vapor deposition (step S90). After that, a circuit pattern was formed as a component 5 of a semiconductor element on the surface of the SiC single crystal epitaxial layer 4, and the circuit pattern was protected with a resin or the like (step S100). After that, the exposed surface side of the SiC polycrystal substrate 1 was ground to form a ground surface 16 (step S110). The back grinding was performed by grinding the back surface of the SiC polycrystal substrate 1 using a grinder manufactured by DISCO. The grinding wheel used for grinding was a 7000-number grinding wheel with a diameter of 200 mm.

### <Measurement of warpage of ground surface 16>

The measurement of warpage of the SiC semiconductor device substrate 6 was performed using a three-dimensional measuring device EMS-3D 300XY manufactured by COMS Co., Ltd. First, the ground surface 16 of the SiC semiconductor device substrate 6 was sucked on the non-full absorption surface, and the height difference data in the ground surface 16 was obtained while the component 5 of the semiconductor element of the SiC semiconductor device substrate 6 was held facing upward. Next, the warpage was calculated as the sum of the maximum and minimum distances from the reference plane. The warpage was measured in the state before grinding in step S110, the state in which the back grinding amount of the SiC polycrystal substrate 1 in step S110 was 150 µm (43% of the thickness of the SiC polycrystal substrate 1), and the state in which it was 175 µm (50% of the thickness of the SiC polycrystal substrate 1). The measurement results are shown in Table 1.

The non-full absorption surface is an absorption surface that can suck and hold three points or one point of the measurement target surface to be measured for warpage without changing the original shape of the substrate, and since the entire surface of the measurement target surface is not sucked, the use of the non-full absorption surface makes it possible to measure the warpage.

### [Example 3]

In Example 3, the warpage of the SiC polycrystal substrate 1 produced in Example 1 was evaluated. First, to evaluate the back grinding, the SiC polycrystal substrate 1 was subjected to a back grinding process under the same conditions as in step S110 in Example 1. In addition, the warpage of the opposite surface 12 of the SiC polycrystal substrate 1 before the back grinding process, and the warpage of the ground surface 13 in a state where the back grinding amount of the SiC polycrystal substrate 1 was 150 µm (43% of the thickness of the SiC polycrystal substrate 1) and a state where the back grinding amount was 175 µm (50% of the thickness of the SiC polycrystal substrate 1) were measured by adsorbing and holding the opposite surface 12 and the ground surface 13 with a non-full adsorption surface. The measurement results are shown in Table 1.

### [Example 2], [Example 4], [Example 5]

In Examples 2, 4, and 5, the warpage of the SiC polycrystal substrate 1 produced under the same conditions as those for producing the SiC polycrystal substrate 1 in Example 1 was evaluated, except that the heat treatment temperature in the heat treatment step was changed to 1600 °C, 1800 °C, and 1900 °C, respectively. As in Example 3, a back grinding process was performed, and the opposite surface 12 and the ground surface 13 were adsorbed and held by the non-entire adsorption surface, and the warpage of the opposite surface 12 and the ground surface 13 was measured. The measurement results are shown in Table 1.

### [Example 6]

In Example 6, the SiC polycrystal substrate 1 was produced under the same conditions as the SiC polycrystal substrate 1 in Example 1, except that the heat treatment temperature in the heat treatment step was changed to 1650 °C and the heat treatment temperature holding time was changed to 3 hours. The SiC bonded substrate 3 was produced under the same conditions as the SiC bonded substrate 3 in Example 1 using this SiC polycrystal substrate 1, and the warpage of the produced SiC bonded substrate 3 was measured. Back grinding was performed on the SiC bonded substrate 3 under the same conditions as step S110 in Example 1. In addition, the warpage of the back surface 14 of the SiC bonded substrate 3 before the back grinding process, the warpage of the ground surface 15 in the state where the back surface grinding amount of the SiC bonded substrate 3 was 150 µm (43% of the thickness of the SiC polycrystal substrate 1) and the state where the back surface grinding amount was 175 µm (50% of the thickness of the SiC polycrystal substrate 1) were measured. The warpage was measured by adsorbing and holding the back surface 14 and the ground surface 15 on the non-full adsorption surface. The measurement results are shown in Table 1.

### [Comparative Example 1]

Except for not carrying out the heat treatment process of step S30, the SiC polycrystal substrate 1, the SiC bonded substrate 3, and the SiC semiconductor device substrate 6 were manufactured in the same manner as in Example 1, and the warpage of the SiC semiconductor device substrate 6 was measured. The measurement results are shown in Table 1.

### [Comparative Example 2]

The warpage of the SiC polycrystal substrate 1 manufactured in Comparative Example 1 was measured in the same manner as in Example 3. The measurement results are shown in Table 1.

### [Comparative Example 3]

The warpage of the SiC bonded substrate 3 manufactured in Comparative Example 1 was measured in the same manner as in Example 6. The measurement results are shown in Table 1.

**[Table 1]**

| | **Substrate for back grinding evaluation** | **Heat Treatment Temperature [°C]** | **Heat treatment temperature holding time [hr.]** | **Amount of warping of the substrate before back grinding[*µ* m]** | **Amount of warpage of the substrate after back grinding[*µ* m]** | |
|---|---|---|---|---|---|---|
| | | | | | **Thickness of SiC polycrystal substrate 1 is 200 *µ* m** | **Thickness of SiC polycrystal substrate 1 is 175*µ* m** |
| **Comparative Example 1** | **Substrate for semiconductor device** | - | - | 59 | 1023 | 1181 |
| **Comparative Example 2** | **Polycrystal SiC** | - | - | 47 | 1031 | 1177 |
| **Comparative Example 3** | **SiC bonded substrate** | - | - | 56 | 1014 | 1153 |
| **Example 1** | **Substrate for semiconductor device** | 1700 | 24 | 60 | 688 | 953 |
| **Example 2** | **Polycrystal SiC** | 1600 | 24 | 55 | 950 | 1094 |
| **Example 3** | **Polycrystal SiC** | 1700 | 24 | 21 | 485 | 851 |
| **Example 4** | **Polycrystal SiC** | 1800 | 24 | 31 | 372 | 808 |
| **Example 5** | **Polycrystal SiC** | 1900 | 24 | 91 | 456 | 757 |
| **Example 6** | **SiC bonded substrate** | 1650 | 3 | 48 | 819 | 1063 |

### (Results and Discussion)

The SiC semiconductor device substrate 6 is composed of the SiC polycrystal substrate 1, the SiC single crystal substrate 2, the SiC single crystal epitaxial layer 4, and the semiconductor element component 5. Among these, the thickness of the SiC polycrystal substrate 1 is sufficiently larger than the others, and since the SiC polycrystal substrate 1 is directly processed in the back grinding, it is understood that the SiC polycrystal substrate 1 has a large effect on warpage. In addition, in the results of Table 1, in all cases of the SiC semiconductor device substrate 6, the SiC bonded substrate 3, and the SiC polycrystal substrate 1, the degree of warpage after back grinding was considerably larger than the warpage before back grinding. From this, it is necessary to improve the warpage of the SiC polycrystal substrate 1 after back grinding in order to prevent the warpage of the substrate caused by back grinding. Comparing Examples 1 to 6 and Comparative Examples 1 to 3 in Table 1, it was found that the warpage can be improved by subjecting the SiC polycrystal substrate 1 to heat treatment.

In Comparative Examples 1 to 3, the warpage after back grinding exceeds 1 mm in each of the SiC semiconductor device substrate 6, the SiC bonded substrate 3, and the SiC polycrystal substrate 1, because no heat treatment process is performed. Also, the warpage after back grinding of the SiC semiconductor device substrate 6, the SiC bonded substrate 3, and the SiC polycrystal substrate 1 is almost the same. From this result, it is inferred that the warpage after back grinding of the SiC semiconductor device substrate 6 is essentially caused by the SiC polycrystal substrate 1. From the results of Examples 1 to 6, it was found that the warpage after back grinding of the SiC semiconductor device substrate 6 can also be improved by improving the warpage after back grinding of the SiC polycrystal substrate 1 alone by heat treatment (Examples 1 to 6).

As described above, the present invention is industrially useful because it can provide a manufacturing method that can reduce the substrate warpage to 1 mm or less when back grinding is performed by back grinding, by a heat treatment process characterized by a long time and high temperature. The heat treatment conditions for reducing the warpage of the substrate after back grinding to 1 mm or less by back grinding include a heat treatment temperature of 1600 °C or more and less than 2000 °C, and a temperature holding time of 3 hours or more.

### Reference Signs List

1 SiC polycrystal substrate
1A SiC polycrystal substrate
2 SiC single crystal substrate
3 SiC bonded substrate
3A SiC bonded substrate
4 SiC single crystal epitaxial layer
5 Component of semiconductor element
6 SiC semiconductor device substrate
7 SiC semiconductor device
8 Drain electrode
11 Front surface
12 Opposite surface
13 Ground surface
14 Back surface
15 Ground surface
16 Ground surface
51 Source electrode
52 Gate electrode
53 Gate insulating film
54 N+ source
55 P well

## Claims

1. A substrate for a SiC semiconductor device, wherein the substrate is formed by stacking
a support substrate made of SiC polycrystal;
a SiC single crystal substrate bonded to a surface of the support substrate;
a SiC single crystal epitaxial layer formed on a surface of the SiC single crystal substrate; and
a component of a semiconductor element formed on the SiC single crystal epitaxial layer; in this sequence,
wherein a surface of the support substrate that is not bonded to the SiC single crystal substrate is a ground surface, and
wherein an amount of warping of the ground surface is 1.0 mm or less.

2. A SiC bonded substrate, wherein the substrate is formed by stacking
a support substrate made of SiC polycrystal; and
a SiC single crystal substrate bonded to a surface of the support substrate;
wherein an amount of warping of a ground surface is 1.0 mm or less in state that a thickness of the support substrate is ground by 40 to 50% to form the ground surface by performing a back grinding process on a surface of the support substrate that is not bonded to the SiC single crystal substrate.

3. A SiC bonded substrate, wherein the substrate is formed by stacking
a support substrate made of SiC polycrystal; and
a SiC single crystal substrate bonded to a surface of the support substrate;
wherein an amount of warping of a ground surface is 1.0 mm or less in state that a thickness of the support substrate is ground by 40 to 44% to form the ground surface by performing a back grinding process on a surface of the support substrate that is not bonded to the SiC single crystal substrate.

4. A SiC polycrystal substrate used as a support substrate for a SiC bonded substrate wherein the support substrate made of SiC polycrystal and a SiC single crystal substrate bonded to a surface of the support substrate are stacked,
wherein an amount of warping of a ground surface is 1.0 mm or less in state that the thickness of the support substrate is ground by 40 to 50% to form the ground surface by performing a back grinding process on a surface of the support substrate that is not bonded to the SiC single crystal substrate.

5. A SiC polycrystal substrate used as a support substrate for a SiC bonded substrate wherein the support substrate made of SiC polycrystal and a SiC single crystal substrate bonded to a surface of the support substrate are stacked,
wherein an amount of warping of a ground surface is 1.0 mm or less in state that a thickness of the support substrate is ground by 40 to 44% to form the ground surface by performing a back grinding process on a surface of the support substrate that is not bonded to the SiC single crystal substrate.

6. A method for manufacturing a SiC polycrystal substrate used as a support substrate for a SiC bonded substrate, wherein the support substrate made of SiC polycrystal and a SiC single crystal substrate bonded to a surface of the support substrate are stacked, the method comprising:
a film formation step of forming a SiC polycrystal film on a seed substrate;
a separation step of separating the seed substrate and the SiC polycrystal film after the film formation step;
a heat treatment step of heat treating the SiC polycrystal film by holding the SiC polycrystal film at 1600 °C or higher and lower than 2000 °C after the separation step; and
a grinding and polishing step of grinding and polishing the SiC polycrystal film to process it into the support substrate after the heat treatment step.

7. The method for manufacturing a SiC polycrystal substrate according to claim 6, wherein the heat treatment step is a step of holding the SiC polycrystal film at a temperature between 1700 °C and 1800 °C for 3 hours or more.
